(19) Europäisches Patentamt
European Patent Office
Office européen des brevets

(11) **EP 3 114 446 B1**

(12) **EUROPEAN PATENT SPECIFICATION**

(45) Date of publication and mention
of the grant of the patent:
**08.05.2019 Bulletin 2019/19**

(21) Application number: **15707153.1**

(22) Date of filing: **03.03.2015**

(51) Int Cl.:
**G01K 7/01** *(2006.01)*          **G01K 7/42** *(2006.01)*

(86) International application number:
**PCT/EP2015/054343**

(87) International publication number:
**WO 2015/132217 (11.09.2015 Gazette 2015/36)**

(54) **METHOD AND APPARATUS FOR CALCULATING THE JUNCTION TEMPERATURE OF AN RF POWER MOSFET**

VERFAHREN UND VORRICHTUNG ZUR BERECHNUNG DER ÜBERGANGSTEMPERATUR EINES RF-LEISTUNGS-MOSFET

PROCÉDÉ ET APPAREIL POUR CALCULER LA TEMPÉRATURE DE JONCTION D'UN MOSFET DE PUISSANCE RF

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.03.2014 PCT/CN2014/072868**
**16.06.2014 EP 14172563**

(43) Date of publication of application:
**11.01.2017 Bulletin 2017/02**

(73) Proprietor: **Koninklijke Philips N.V.**
**5656 AE Eindhoven (NL)**

(72) Inventors:
• **ZENG, Keqiu**
**NL-5656 AE Eindhoven (NL)**
• **WANG, Tao**
**NL-5656 AE Eindhoven (NL)**
• **SENAN, Kailas**
**NL-5656 AE Eindhoven (NL)**

(74) Representative: **Steffen, Thomas**
**Philips Intellectual Property & Standards**
**High Tech Campus 5**
**5656 AE Eindhoven (NL)**

(56) References cited:
**US-A1- 2002 118 841     US-A1- 2012 278 029**

• **Maxat N Touzelbaev ET AL: "High-efficiency transient temperature calculations for applications in dynamic thermal management of electronic devices", Journal of Electronic Packaging, September 2013 (2013-09), XP055155749, DOI: 10.1115/1.4024747] Retrieved from the Internet: URL:https://nanoheat.stanford.edu/sites/de fault/files/publications/Touzelbaev et al. 2013.pdf**
• **YOUMIN YU ET AL: "Compact Thermal Resistor-Capacitor-Network Approach to Predicting Transient Junction Temperatures of a Power Amplifier Module", IEEE TRANSACTIONS ON COMPONENTS, PACKAGING AND MANUFACTURING TECHNOLOGY, vol. 2, no. 7, July 2012 (2012-07), pages 1172-1181, XP055155750, ISSN: 2156-3950, DOI: 10.1109/TCPMT.2012.2198885**
• **LEE J H ET AL: "Large time-scale electro-thermal simulation for loss and thermal management of power MOSFET", PESC'03. 2003 IEEE 34TH. ANNUAL POWER ELECTRONICS SPECIALISTS CONFERENCE. CONFERENCE PROCEEDINGS. ACAPULCO, MEXICO, JUNE 15 - 19, 2003; [ANNUAL POWER ELECTRONICS SPECIALISTS CONFERENCE], NEW YORK, NY :; IEEE, US, vol. 1, 15 June 2003 (2003-06-15), pages 112-117, XP010649004, DOI: 10.1109/PESC.2003.1218282 ISBN: 978-0-7803-7754-7**

**Description**

FIELD OF THE INVENTION

The invention relates to semiconductor temperature measurement, in particular relates to a method and apparatus for calculating the junction temperature of an RF power MOSFET.

BACKGROUND OF THE INVENTION

Radio frequency (RF) metallic oxide semiconductor field effect transistors (MOSFETs) are the most important elements in a magnetic resonance imaging (MRI) amplifier. Most of the MRI failure is caused by MOSFETs, and most of the MOSFET failure is caused by internal overheat of junction temperature of MOSFETs. Thus, it is essential to detect junction temperature of MOSFETs in an accurate and fast way to ensure the MRI amplifier working well. However, because the MOSFETs are sealed in packages, it is impossible to detect junction temperature directly with thermoprobes or infrared detectors.

The solution for solving the above problem in the prior art is analog simulation. That is, though it is impossible to detect junction temperature directly with thermoprobes or infrared detectors, the junction temperature of an MOSFET can be derived by establishing a transient thermal impedance model which is equivalent to the MOSFET and then inputting an actual input signal with an actual power to transient thermal impedance model. The output of the transient thermal impedance model represents the junction temperature of the MOSFET.

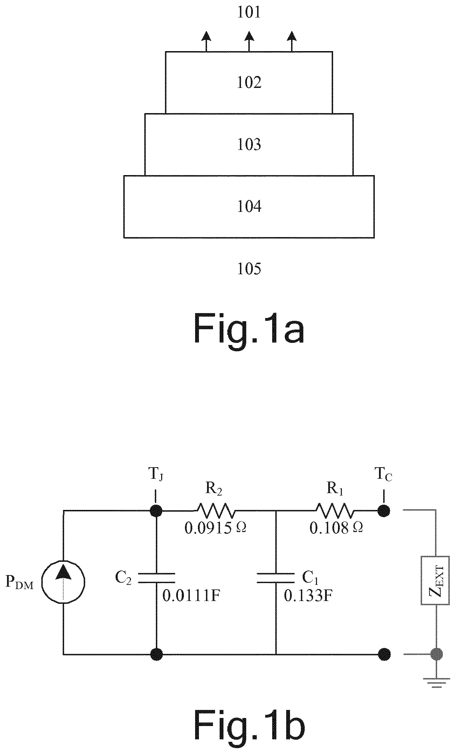

In the prior art, there are many ways for establishing the transient thermal impedance model which is equivalent to the MOSFET. Fig. 1a shows a typical MOSFET heat dissipation structure and Fig. 1b shows its equivalent transient thermal impedance model in the prior art.

As shown in Fig. 1a, heat generated within a junction 101 in a silicon chip 102 of the MOSFET is typically dissipated to a case 103, a heat sink 104 and ambient surroundings 105. Temperature loss from junction 101 to case 103 is considered here for thermal impedance estimation. Temperature loss from case 103 to heat sink 104 and from heat sink 104 to ambient surroundings 105 are ignored and set to zero.

Fig. 1b shows an equivalent transient thermal impedance model of the structure of Fig. 1a. The input of the equivalent transient thermal impedance model is the actual dissipated power $P_{DM}$ in the MOSFET, and the output is the junction temperature $T_J$, which is calculated from the below equation.

$$T_J = \Delta T_{JC} + T_C$$
$$= (P_{DM} \times Z_{qJC}) + T_C$$

Where,

$T_J$ - Junction Temperature (°C)
$T_C$ - Case Temperature (°C)
$\Delta T_{JC}$ - Temperature transferred from Junction to Case
$P_{DM}$ - Dissipation Power of the MOSFET (Watts)
$Z_{qJC}$ - Junction-to-Case Thermal Impedance (°C/watts)

Initially, when the MOSFET is not used, i.e. the $P_{DM}$ is not applied, the $\Delta T_{JC} = 0$ and $T_J = T_C$. After the $P_{DM}$ is applied, heat is transferred from the junction to the case and the junction temperature $T_J$ is increased by $\Delta T_{JC}$, which is equal to result of multiplying $P_{DM}$ by Junction-to-Case Thermal Impedance $Z_{qJC}$. $Z_{qJC}$ is analogue to electrical impedance in the electrical field. $Z_{qJC}$ is defined by a ratio of increased temperature to the applied power, which is increased temperature (°C) per 1 watt applied, while the electrical impedance is defined by a ratio of a voltage to a current, which is increased voltage (V) per 1 ampere applied. $R_1$, $R_2$, $C_1$, $C_2$ in Fig. 1b are all thermal resistors or thermal capacitors, not electrical resistors or electrical capacitors. Different MOSFETs have different values of $R_1$, $R_2$, $C_1$, $C_2$, which are calculated when out of factories and usually listed in the product specification. $Z_{EXT}$ in Fig. 1b represents external thermal impendence including case-to-sink thermal impedance and sink-to-ambient thermal impedance, which are usually set to zero. Thus, an analog circuit which is analog to the equivalent transient thermal impedance model in Fig. 1b can be established, which has electrical resistors and electrical capacitors with the same ohm values as the thermal resistors and the thermal capacitors and current value of the current source with the same ampere values with $P_{DM}$. Then the volt value of the voltage across the current source is the same with the °C value of $T_J$, and thus $T_J$ can be read from the measured volt value of the voltage across the current source.

The drawback of the above analog circuit solution is low accuracy due to low precision of actual electrical elements such as electrical resistors and electrical capacities adopted in the analog circuit. If the electrical elements such as electrical resistors and electrical capacities are selected and tested in high accuracy, time cost is high.

Maxat N. Touzelbaev, et al. "High-efficiency transient temperature calculations for applications in dynamic thermal management of electronic devices", and US 2012/278029 A1, disclose a method for calculating transient temperature based on resistor-capacitor (RC) network which is converted into a 1st order infinite impulse response (IIR) digital filter. Further, Youmin Yu et al.:"Compact thermal resistor-capacitor-network approach to predicting transient junction temperatures of a powe amplifier module", July 2012, and Lee J H et al.:"Large time-scale electro-thermal simulation for loss and thermal management of power MOSFET", 15 June 2003 relate to junction temperature models in the analog domain. US 2002/118841 A1 describes a compensation system capable of compensating for power loss due to the power compression effects of the voice coil as the temperature of the voice coil increases. To compensate for the power compression effect, this system predicts or estimates the temperature of the voice coil using a thermal-model, and adjusts the estimated temperature according to the cooling effect as the voice coil moves back and forth in the air gap.

SUMMARY OF THE INVENTION

Based on understanding of the technical problems and prior art described above, it will be desirable to determine the junction temperature of an RF power MOSFET in high accuracy and acceptable time cost.

This object is addressed by the subject matter of the independent claims. Preferred embodiments are described in the sub claims.

According to one aspect of this invention, there is provided a method for calculating the junction temperature of an RF power MOSFET, comprising steps of: establishing a transient thermal impedance model of the RF power MOSFET in analog domain; calculating a transfer function in time domain of the transient thermal impedance model using bilinear transformation; establishing a junction temperature compensation model in digital domain based on the transfer function in time domain of the transient thermal impedance model with a preferable sampling frequency and a type of $2^{nd}$ order IIR filter structure; and calculating the junction temperature of the RF power MOSFET by inputting an actual input to the junction temperature compensation model.

Because this invention does not adopt an analog circuit solution, and instead, establishes a junction temperature compensation model in digital domain, which can be realized logically by software or firmware without physically establishing actual analog circuits, it removes influence due to low precision of actual electrical elements adopted in the analog circuit and thus improves accuracy of determining the junction temperature of an RF power MOSFET.

Optionally, the preferable sampling frequency is selected as 10KHz.

Optionally, the type of $2^{nd}$ order IIR filter structure is selected as direct form II IIR filter structure.

The 10KHz sampling frequency and the direct form II IIR filter structure can help further improve accuracy of determining the junction temperature of an RF power MOSFET, which are proved by simulation results.

According to another aspect of this invention, there is provided an apparatus for calculating the junction temperature of an RF power MOSFET, comprising: a first establishing unit configured to establish a transient thermal impedance model of the RF power MOSFET in analog domain; a first calculating unit configured to calculate a transfer function in time domain of the transient thermal impedance model using bilinear transformation; a second establishing unit configured to establish a junction temperature compensation model in digital domain based on the transfer function in time domain of the transient thermal impedance model with a preferable sampling frequency and a type of $2^{nd}$ order IIR filter structure; and a second calculating unit configured to calculate the junction temperature of the RF power MOSFET by inputting an actual input to the junction temperature compensation model.

According to another aspect of this invention, there is provided a computer executable program recorded in a computer readable medium and which can be executed by a computer to perform a method for calculating the junction temperature of an RF power MOSFET when loaded to the computer, comprising instruction codes of: establishing a transient thermal impedance model of the RF power MOSFET in analog domain; calculating a transfer function in time domain of the transient thermal impedance model using bilinear transformation; establishing a junction temperature compensation model in digital domain based on the transfer function in time domain of the transient thermal impedance model with a sampling frequency and a type of $2^{nd}$ order IIR filter structure; and calculating the junction temperature of the RF power MOSFET by inputting an actual input to the junction temperature compensation model.

According to another aspect of this invention, there is provided a magnetic resonance imaging (MRI) system comprising a MRI amplifier, the MRI system further comprises the apparatus for calculating the junction temperature of at least one RF power MOSFET used in the MRI amplifier.

These and other aspects of the invention will be apparent from and elucidated with reference to the embodiments described hereinafter.

DESCRIPTION OF THE DRAWINGS

The above and other objects and features of the present invention will become more apparent from the following detailed description considered in connection with the accompanying drawings, in which:

Fig. 1a shows a typical MOSFET heat dissipation structure and Fig. 1b shows its equivalent transient thermal impedance model in the prior art;
Fig. 2 shows a flow chart of a method for calculating the junction temperature of an RF power MOSFET according to an embodiment of this invention;
Fig. 3 shows a detailed flow chart of step S2 in Fig. 2 according to an embodiment of this invention;
Fig. 4 shows a detailed flow chart of step S3 in Fig. 2 according to an embodiment of this invention;
Fig. 5 shows an example of a direct form II IIR filter structure selected for establishing the junction temperature compensation model according to an embodiment of this invention; and
Fig. 6 shows a block figure of an apparatus for calculating the junction temperature of an RF power MOSFET according to an embodiment of this invention.

The same reference numerals are used to denote similar parts throughout the figures.

DETAILED DESCRIPTION

Detailed description of the present invention is given below in connection with the accompanying drawings.

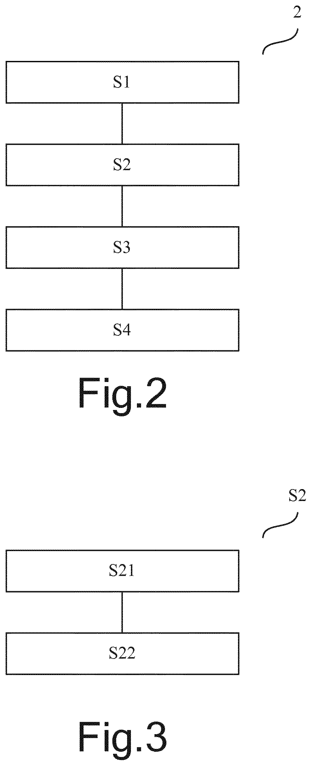

Fig. 2 shows a flow chart of a method for calculating the junction temperature of an RF power MOSFET according to an embodiment of this invention.
According to an embodiment of this invention, a method 2 for calculating the junction temperature of an RF power MOSFET is provided.
The method 2 for calculating the junction temperature of an RF power MOSFET can be used to calculating the junction temperature of any kind of RF power MOSFET, including a medical instrument specific RF power MOSFET or non-medical instrument specific RF power MOSFET, an RF power MOSFET in an MRI amplifier or an RF power MOSFET in other electrical elements. Because MOSFETs are the most critical elements in an MRI amplifier, the method 2 may have a better applying prospect for the RF power MOSFETs in an MRI amplifier.
The method 2 can be realized by an embedded component which is embedded into the instrument where the RF power MOSFET is incorporated, or by an independent device such as a general computer loaded with corresponding software.
As seen from Fig. 2, the method 2 comprises step S1 of establishing a transient thermal impedance model of the RF power MOSFET in analog domain.
The transient thermal impedance model of the RF power MOSFET (as in Fig. 1b) can be established in many ways. For example, as stated in the above background portion, $R_1$, $R_2$, $C_1$, $C_2$, etc. are calculated when out of factories and usually listed in the product specification, thus, the transient thermal impedance model of the RF power MOSFET can be established by means of inputting parameters such as $R_1$, $R_2$, $C_1$, $C_2$, etc. by an operator or automatically recognizing the scanned product specification by a general computer loaded with character recognizing software, etc. Another way for establishing a transient thermal impedance model of the RF power MOSFET is testing as the same with what is did when the MOSFET is out of factories if the product specification does not contain such information. There are many ways for such testing in the prior art.
The method 2 further comprises step S2 of calculating a transfer function in time domain of the transient thermal impedance model using bilinear transformation.
The transfer function of the transient thermal impedance model means output of the transient thermal impedance model, i.e. the junction temperature of the RF power MOSFET, divided by input of the transient thermal impedance model, i.e. the power generated when the RF power MOSFET works. Still taking Fig.1b as example, the transfer function of the transient thermal impedance model can be represented as follows:

$$Z_{qJC} = \left( \left( R_1 \| C_1 \right) + R_2 \right) \| C_2 + Z_{EXT}$$

wherein $R_1$, $R_2$, $C_1$, $C_2$ are thermal resistors or thermal capacitors, which are discussed in the background portion. $Z_{EXT}$ is external thermal impendence, which is discussed also in the background portion and usually set to zero. If $Z_{EXT}$ is set to zero, the transfer function of the transient thermal impedance model can be simplified as follows:

$$Z_{qJC} = \left( \left( R_1 \| C_1 \right) + R_2 \right) \| C_2 .$$

The transfer function in time domain of the transient thermal impedance model can be computed in many ways. For example, it can be computed as in Fig. 3 by calculating a transfer function in frequency domain of the transient thermal impedance model in step S21 and converting the transfer function in frequency domain of the transient thermal impedance model into the transfer function in time domain of the transient thermal impedance model using bilinear transformation in step S22. Detailed procedure of step S21 and step S22 will be described later. As another example, the transfer function in time domain of the transient thermal impedance model can be computed directly by a known specific tool.

The bilinear transformation is a known method in signal processing for converting frequency domain representation (S plane) into time domain representation (Z plane).

The method 2 further comprises step S3 of establishing a junction temperature compensation model in digital domain based on the transfer function in time domain of the transient thermal impedance model with a preferable sampling frequency and a type of 2nd order IIR filter structure.

The junction temperature compensation model means the model that will be used in calculating the junction temperature of an RF power MOSFET according to an embodiment of this invention.

The sampling frequency is a parameter of the transfer function in time domain of the transient thermal impedance model and thus only after the sampling frequency is fixed, the transfer function in time domain of the transient thermal impedance model is fixed. Any sampling frequency could be adopted if the sampling principle is satisfied. With a preferable sampling frequency satisfying the sampling principle, the accuracy in determining the junction temperature of an RF power MOSFET can be improved. The preferable sampling will be discussed later.

The junction temperature compensation model in digital domain can be established by common technology in signal processing based on the transfer function in time domain. Its structure is related to the type of 2nd order IIR filter structure. With different types of 2nd order IIR filter structures, the structures of established junction temperature compensation models are different. Though they can all improve accuracy in determining the junction temperature of an RF power MOSFET, the preferable type will be discussed later.

The method 2 further comprises step S4 of calculating the junction temperature of the RF power MOSFET by inputting an actual input to the junction temperature compensation model.

Here, the actual input means an input signal representing the monitored power generated when the RF power MOSFET works. After the junction temperature compensation model is realized by software or firmware simulation, with the actual input representing the power generated when the RF power MOSFET works, the output of the junction temperature compensation model realized by software or firmware simulation is the junction temperature of an RF power MOSFET. The power generated when the RF power MOSFET works can be computed by real-time monitoring the voltage and the current of the RF power MOSFET and multiplying the voltage and the current.

Because the junction temperature compensation model is in digital domain, it can be simulated by software or firmware without physically establishing the actual analog circuit, thus improving accuracy in determining the junction temperature of an RF power MOSFET. In software realization, step S4 is implemented by software simulation, i.e. the digital units in the junction temperature compensation model are realized as logical blocks by software. It can be realized by many ways. For example, it can be realized by Matlab Simulink tool. In firmware realization, step S4 is implemented by FPGA, i.e. the digital units in the junction temperature compensation model are realized as logical blocks but the logical blocks are respectively written to individual physical chips (hardwares). For example, it can be realized using JTAG hardware-in-loop simulation with Xilinx Spartan-6 FPGA development board.

Now let us discuss the detailed procedures of step S21 and step S22 in Fig. 3.

Step 21 of calculating a transfer function in frequency domain of the transient thermal impedance model can be performed as follows: assuming corresponding thermal impedance for a resistor R being R, corresponding thermal impedance for an inductor L being sL, corresponding thermal impedance for a capacitor C being 1/sC, the transfer function in frequency domain of the transient thermal impedance model, which is equal to the total thermal impedance of the transient thermal impedance model, can be thus calculated. Still taking Fig. 1b for example,

$$H_{(s)} = \left( \left( R_1 \parallel C_1 \right) + R_2 \right) \parallel C_2$$

$$= \left( \left( R_1 \times 1/s\,C_1 \right)/\left( R_1 + 1/s\,C_1 \right) + R_2 \right) \parallel C_2$$

$$= \left( \frac{R_1}{1 + sR_1C_1} + R_2 \right) \parallel C_2$$

$$= \left( \frac{R_1 + sR_1C_1R_2 + R_2}{1 + sR_1C_1} \right) \parallel C_2$$

$$= \frac{\left( \dfrac{R_1 + sR_1C_1R_2 + R_2}{1 + sR_1C_1} \right)}{1 + s\left( \dfrac{R_1 + sR_1C_1R_2 + R_2}{1 + sR_1C_1} \right)C_2}$$

$$= \frac{R_1 + sR_1C_1R_2 + R_2}{1 + sR_1C_1 + sR_1C_2 + s^2R_1C_1R_2C_2 + sR_2C_2}$$

where s is the complex frequency, after substituting $R_1$, $R_2$, $C_1$, $C_2$ values into $H_{(s)}$,

$$H_{(s)} = \frac{0.108 + \left( s0.108 \times 0.133 \times 0.0915 \right) + 0.0915}{1 + \left( s0.108 \times 0.133 \right) + \left( s0.108 \times 0.0111 \right) + \left( s^2 0.108 \times 0.133 \times 0.0915 \times 0.0111 \right) + \left( s0.0915 \times 0.0111 \right)}$$

$$= \frac{0.108 + 0.00131430\,6s + 0.0915}{1 + 0.014364\,s + 0.0011988\,s + 0.00001458\,87966\,s^2 + 0.00101565\,s}$$

$$= \frac{0.001314306s + 0.1995}{0.0000145887966s^2 + 0.01657845s + 1}$$

Step S22 of converting the transfer function in frequency domain of the transient thermal impedance model into the transfer function in time domain of the transient thermal impedance model using bilinear transformation is performed as follows.

The bilinear transformation is a known method in signal processing for converting frequency domain representation (S plane) into time domain representation (Z plane). It first compresses a j $\Omega$ axis in an S plane into a section of a j $\Omega$ axis in an S1 plane so that the S plane is compressed into a band of the S1 plane, and then converts the band into the whole Z plane. Its advantage over other methods such as an impulse response constant method is removing aliasing due to frequency spectrum overlap, so it could be used in this invention to ensure high accuracy in determining the junction temperature of an RF power MOSFET.

By this method, the transfer function $H_{(z)}$ in time domain of the transient thermal impedance model can be obtained by substituting $s = \frac{2f_s(Z\text{-}1)}{(Z+1)}$ into $H_{(s)}$. Still taking the above example,

$$H_{(z)} = H_{(s)} \bigg|_{s = \frac{2f_s(Z\text{-}1)}{(Z+1)}}$$

$$= \frac{0.001314306\left(\dfrac{2f_s(Z\text{-}1)}{(Z+1)}\right) + 0.1995}{0.0000145887966\left(\dfrac{2f_s(Z\text{-}1)}{(Z+1)}\right)^2 + 0.01657845\left(\dfrac{2f_s(Z\text{-}1)}{(Z+1)}\right) + 1}$$

where $f_s$ is the sampling frequency in hertz.

Coefficients in numerator of $H_{(s)}$ in descending powers of s are Num = [0.001314306 0.1995]. Coefficients in denominator of $H_{(s)}$ in descending powers of s are Den = [0.0000145887966 0.01657845 1]. After applying bilinear function [Numz, Denz] = bilinear (Num, Den, $f_s$) to Num [0.001314306 0.1995] and Den [0.0000145887966 0.01657845 1], coefficients in numerator of $H_{(z)}$ in descending powers of z, i.e. Numz [$x_0$ $x_1$ $x_2$] and coefficients in denominator of $H_{(z)}$ in descending powers of z, i.e. Numz [$y_0$ $y_1$ $y_2$] are obtained. Thus, $H_{(z)}$ is obtained as follows:

$$H_{(z)} = \frac{x_0 + x_1 Z^{-1} + x_2 Z^{-2}}{y_0 + y_1 Z^{-1} + y_2 Z^{-2}}.$$

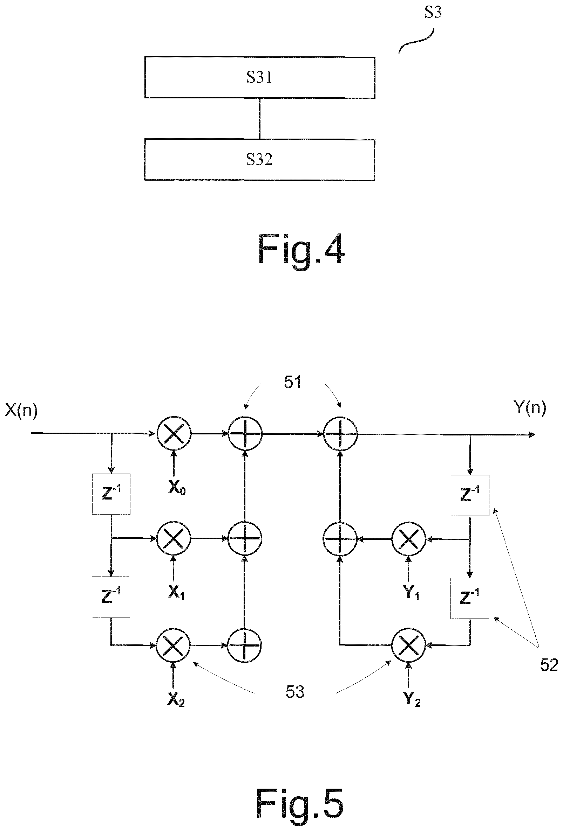

As shown in Fig. 4, step S3 comprises step S31 of selecting the sampling frequency for establishing the junction temperature compensation model.

Coefficients $x_0$, $x_1$, $x_2$, $y_0$, $y_1$, $y_2$ of $H_{(z)}$ are related to the sampling frequency $f_s$. That is, with different sampling frequency $f_s$, $H_{(z)}$ is different. Therefore, the sampling frequency can be selected by first assuming different sampling frequencies so that different junction temperature compensation models can be established in step S3 and different junction temperatures of the RF power MOSFET can be calculated in step S4, and comparing the different junction temperatures of the RF power MOSFET with a theory temperature value. The frequency resulting in the smallest difference between the calculated junction temperature and the theory temperature value is selected as the sampling frequency for establishing the junction temperature compensation model. The theory temperature value may be obtained in many ways. For example, it may be obtained from analog simulation where the resistors and capacitors are selected and tested in high accuracy though the time cost may be high for doing that.

Based on comparison of simulation results for different sampling frequencies with the theory temperature value, if the sampling frequency for establishing the junction temperature compensation model is selected as 10KHz, the accuracy in determining the junction temperature of an RF power MOSFET is further improved.

Step S3 further comprises step S32 of selecting the type of 2nd order IIR filter structure for establishing the junction temperature compensation model.

With different types of 2nd order IIR filter structures, the junction temperature compensation models are different. Therefore, the type of 2nd order IIR filter structure for establishing the junction temperature compensation model can be selected by first assuming different types of of 2nd order IIR filter structures for establishing the junction temperature compensation model, such as direct form I IIR filter structure, direct form II IIR filter structure, transposed filter structure, etc., and then comparing the different junction temperatures of the RF power MOSFET thus calculated with a theory temperature value. The type of 2nd order IIR filter structure resulting in the smallest difference between the calculated junction temperature and the theory temperature value is selected as the type of 2nd order IIR filter structure for establishing the junction temperature compensation model. The theory temperature value may be obtained in many ways. For example, it may be obtained from analog simulation where the resistors and capacitors are selected and tested in high accuracy though the time cost may be high for doing that.

Based on comparison of simulation results for different types of 2nd order IIR filter structures with the theory temperature value, if the type of 2nd order IIR filter structure for establishing the junction temperature compensation model is selected as direct form II IIR filter structure, the accuracy in determining the junction temperature of an RF power MOSFET is further improved.

Fig. 5 shows an example of a direct form II IIR filter structure selected for establishing the junction temperature compensation model based on the transfer function in time domain of the transient thermal impedance model

$$H_{(z)} = \frac{x_0 + x_1 Z^{-1} + x_2 Z^{-2}}{y_0 + y_1 Z^{-1} + y_2 Z^{-2}}$$ according to an embodiment of this invention, wherein $y_0$ =1. In Fig. 5, reference sign 53 represents a multiplier, reference sign 51 represents an adder, and reference sign 52 represents a delay element.

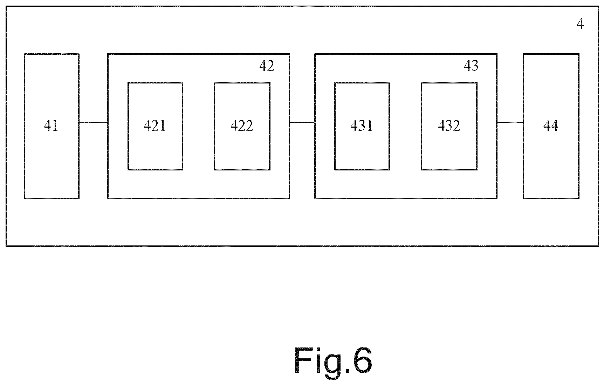

Fig. 6 shows a block figure of an apparatus 4 for calculating the junction temperature of an RF power MOSFET according to an embodiment of this invention. The apparatus 4 comprises a first establishing unit 41, a first calculating unit 42, a second establishing unit 43 and a second calculating unit 44.

The first establishing unit 41 is configured to establish a transient thermal impedance model of the RF power MOSFET in analog domain. The first establishing unit 41 can be realized in many ways. For example, it can be realized as a receipt module for receiving parameters such as $R_1$, $R_2$, $C_1$, $C_2$, etc. input by an operator according to the product specification made when out of factories, or can be realized as a recognizing module for automatically recognizing the scanned product specification.

The first calculating unit 42 is configured to calculate a transfer function in time domain of the transient thermal impedance model using bilinear transformation.

The second establishing unit 43 is configured to establish a junction temperature compensation model in digital domain based on the transfer function in time domain of the transient thermal impedance model with a sampling frequency and a type of 2nd order IIR filter structure.

The second calculating unit 44 is configured to calculate the junction temperature of the RF power MOSFET by inputting an actual input to the junction temperature compensation model. There are many ways to calculate the junction temperature of the RF power MOSFET in the second calculating unit 44. For example, the second calculating unit 44 may be configured to calculate the junction temperature of the RF power MOSFET by software simulation. As another example, the second calculating unit 44 is configured to calculate the junction temperature of the RF power MOSFET by FPGA.

As shown in Fig. 6, in an embodiment, the first calculating unit 42 comprises a third calculating unit 421 and a converting unit 422. The third calculating unit 421 is configured to calculate a transfer function in frequency domain of the transient thermal impedance model. The converting unit 422 is configured to convert the transfer function in frequency domain of the transient thermal impedance model into the transfer function in time domain of the transient thermal impedance model using bilinear transformation.

Also as shown in Fig. 6, in an embodiment, the second establishing unit 43 comprises a first selecting unit 431 and a second selecting unit 432. The first selecting unit 431 is configured to select the sampling frequency for establishing the junction temperature compensation model. The second selecting unit 432 is configured to select the type of 2nd order IIR filter structure for establishing the junction temperature compensation model.

Each unit in Fig. 6 may be an embedded component which is embedded into the instrument where the RF power MOSFET is incorporated. Or, all the units in Fig. 6 are realized by a device outside the instrument where the RF power MOSFET is incorporated, such as a general computer loaded with corresponding software.

Further, according to an embodiment of this invention, this invention may be embodied as a computer executable program recorded in a computer readable medium and which can be executed by e.g. a general computer to perform a method for calculating the junction temperature of an RF power MOSFET when loaded to the computer, comprising instruction codes of: establishing a transient thermal impedance model of the RF power MOSFET in analog domain; calculating a transfer function in time domain of the transient thermal impedance model using bilinear transformation; establishing a junction temperature compensation model in digital domain based on the transfer function in time domain of the transient thermal impedance model with a sampling frequency and a type of 2nd order IIR filter structure; and calculating the junction temperature of the RF power MOSFET by inputting an actual input to the junction temperature compensation model. The general computer may comprise a CPU, a memory, an input/output interface, etc.

**Claims**

1. A method for calculating the junction temperature of an RF power MOSFET, comprising steps of:

    establishing (S1) a transient thermal impedance model of the RF power MOSFET in analog domain;
    calculating (S2) a transfer function in time domain of the transient thermal impedance model using bilinear transformation;
    selecting a preferable sampling frequency and a preferable type of 2nd order IIR filter structure to establish (S3) a junction temperature compensation model in digital domain based on the transfer function in time domain of the transient thermal impedance model; and
calculating (S4) the junction temperature of the RF power MOSFET by inputting an actual input to the junction temperature compensation model.

2. The method according to claim 1, wherein the step of calculating (S2) a transfer function in time domain of the transient thermal impedance model comprises steps of:

    calculating (S21) a transfer function in frequency domain of the transient thermal impedance model;
    converting (S22) the transfer function in frequency domain of the transient thermal impedance model into the transfer function in time domain of the transient thermal impedance model using bilinear transformation.

3. The method according to claim 1, wherein the step of selecting a preferable sampling frequency comprises steps of:

    establishing a plurality of junction temperature compensation models with a plurality of sampling frequencies;
    calculating a plurality of junction temperatures using the plurality of estabiished junction temperature compensation models; and
    selecting the sampling frequency that results in the minimum difference between a predetermined theory temperature value and the calcuated junction temperatures as the preferable sampling frequency.

4. The method according to claim 1, wherein the step of selecting a preferable type of $2^{nd}$ order IIR filter structure comprises steps of:

    establishing a plurality of junction temperature compensation models with a plurality of types of the $2^{nd}$ order IIR filter structure ;
    calculating a plurality of junction temperatures using the plurality of estabiished junction temperature compensation models; and
    selecting the type of the $2^{nd}$ order IIR filter structure that results in the minimum difference between a predetermined theory temperature value and the calculated junction temperatures as the preferable type of $2^{nd}$ order IIR filter structure.

5. The method according to claim 1, wherein the preferable sampling frequency is selected as 10KHz.

6. The method according to claim 1, wherein the type of $2^{nd}$ order IIR filter structure is selected as direct form II IIR filter structure.

7. The method according to claim 1, wherein the step of calculating (S4) the junction temperature of the RF power MOSFET is implemented by software simulation.

8. The method according to claim 1, wherein the step of calculating (S4) the junction temperature of the RF power MOSFET is implemented by FPGA.

9. An apparatus for calculating the junction temperature of an RF power MOSFET, comprising:

    a first establishing unit (41) configured to establish a transient thermal impedance model of the RF power MOSFET in analog domain;
    a first calculating unit (42) configured to calculate a transfer function in time domain of the transient thermal impedance model using bilinear transformation;
    a second establishing unit (43) configured to establish a junction temperature compensation model in digital domain based on the transfer function in time domain of the transient thermal impedance model by selecting a preferable sampling frequency and a preferable type of $2^{nd}$ order IIR filter structure; and
    a second calculating unit (44) configured to calculate the junction temperature of the RF power MOSFET by inputting an actual input to the junction temperature compensation model.

10. The apparatus according to claim 9, wherein the first calculating unit (42) comprises:

    a third calculating unit (421) configured to calculate a transfer function in frequency domain of the transient thermal impedance model;
    a converting unit (422) configured to convert the transfer function in frequency domain of the transient thermal impedance model into the transfer function in time domain of the transient thermal impedance model using bilinear transformation.

11. The apparatus according to claim 9, wherein the preferable sampling frequency for establishing the junction temperature compensation model is selected as 10KHz.

12. The apparatus according to claim 9, wherein the preferable type of 2nd order IIR filter structure for establishing the junction temperature compensation model is selected as direct form II IIR filter structure.

13. The apparatus according to claim9, wherein the second calculating unit (44) is configured to calculate the junction temperature of the RF power MOSFET by software simulation.

14. The apparatus according to claim 9, wherein the second calculating unit (44) is configured to calculate the junction temperature of the RF power MOSFET by FPGA.

15. A magnetic resonance imaging (MRI) system comprising a MRI amplifier, wherein the MRI system further comprises the apparatus according to one of the claims 8 to 14 for calculating the junction temperature of at least one RF power MOSFET used in the MRI amplifier.

**Patentansprüche**

1. Verfahren zur Berechnung der Übergangstemperatur eines HF-Leistungs-MOSFET, das die folgenden Schritte umfasst:

Erstellen (S1) eines Modells für die transiente thermische Impedanz des HF-Leistungs-MOSFET im analogen Bereich;
Berechnen (S2) einer Transferfunktion im Zeitbereich des Modells für die transiente thermische Impedanz unter Verwendung von bilinearer Transformation;
Auswählen einer vorzuziehenden Abtastfrequenz und eines vorzuziehenden Typs von Filterstruktur zweiter Ordnung mit unendlicher Impulsantwort (engl. IIR-Filter) zum Erstellen (S3) eines Modells für die Übergangstemperaturkompensation im digitalen Bereich basierend auf der Transferfunktion im Zeitbereich des Modells für die transiente thermische Impedanz; und
Berechnen (S4) der Übergangstemperatur des HF-Leistungs-MOSFET durch Eingeben einer tatsächlichen Eingabe in das Modell für die Übergangstemperaturkompensation.

2. Verfahren nach Anspruch 1, wobei der Schritt des Berechnens (S2) einer Transferfunktion im Zeitbereich des Modells für die transiente thermische Impedanz die folgenden Schritte umfasst:

Berechnen (S21) einer Transferfunktion im Frequenzbereich des Modells für die transiente thermische Impedanz;
Umwandeln (S22) der Transferfunktion im Frequenzbereich des Modells für die transiente thermische Impedanz in die Transferfunktion im Zeitbereich des Modells für die transiente thermische Impedanz unter Verwendung von bilinearer Transformation.

3. Verfahren nach Anspruch 1, wobei der Schritt des Auswählens einer vorzuziehenden Abtastfrequenz die folgenden Schritte umfasst:

Erstellen einer Vielzahl von Modellen für die Übergangstemperaturkompensation mit einer Vielzahl von Abtastfrequenzen;
Berechnen einer Vielzahl von Übergangstemperaturen unter Verwendung der Vielzahl von erstellten Modellen für die Übergangstemperaturkompensation; und
Auswählen der Abtastfrequenz, die zu der minimalen Differenz zwischen einen vorgegebenen theoretischen Temperaturwert und den berechneten Übergangstemperaturen führt, als die vorzuziehende Abtastfrequenz.

4. Verfahren nach Anspruch 1, wobei der Schritt des Auswählens eines vorzuziehenden Typs von Filterstruktur zweiter Ordnung mit unendlicher Impulsantwort die folgenden Schritte umfasst:

Erstellen einer Vielzahl von Modellen für die Übergangstemperaturkompensation mit einer Vielzahl von Typen von Filterstrukturen zweiter Ordnung mit unendlicher Impulsantwort;

Berechnen einer Vielzahl von Übergangstemperaturen unter Verwendung der Vielzahl von erstellten Modellen für die Übergangstemperaturkompensation; und

Auswählen des Typs von Filterstruktur zweiter Ordnung mit unendlicher Impulsantwort, der zu der minimalen Differenz zwischen einem vorgegebenen theoretischen Temperaturwert und den berechneten Übergangstemperaturen führt, als den vorzuziehenden Typ von Filterstruktur zweiter Ordnung mit unendlicher Impulsantwort.

5. Verfahren nach Anspruch 1, wobei die vorzuziehende Abtastfrequenz als 10 kHz ausgewählt wird.

6. Verfahren nach Anspruch 1, wobei der Typ von Filterstruktur zweiter Ordnung mit direkter Impulsantwort als Direkte-Form-II-Filterstruktur mit unendlicher Impulsantwort ausgewählt wird.

7. Verfahren nach Anspruch 1, wobei der Schritt des Berechnens (S4) der Übergangstemperatur des HF-Leistungs-MOSFET durch Software-Simulation implementiert wird.

8. Verfahren nach Anspruch 1, wobei der Schritt des Berechnens (S4) der Übergangstemperatur des HF-Leistungs-MOSFET durch FPGA implementiert wird.

9. Gerät zur Berechnung der Übergangstemperatur eines HF-Leistungs-MOSFET, umfassend:

eine erste Erstellungseinheit (41), die konfiguriert ist, um ein Modell für die transiente thermische Impedanz des HF-Leistungs-MOSFET im analogen Bereich zu erstellen;

eine erste Berechnungseinheit (42), die konfiguriert ist, um eine Transferfunktion im Zeitbereich des Modells für die transiente thermische Impedanz unter Verwendung von bilinearer Transformation zu berechnen;

eine zweite Erstellungseinheit (43), die konfiguriert ist, um ein Modell für die Übergangstemperaturkompensation im digitalen Bereich basierend auf der Transferfunktion im Zeitbereich des Modells für die transiente thermische Impedanz zu erstellen, indem eine vorzuziehende Abtastfrequenz und ein vorzuziehender Typ von Filterstruktur zweiter Ordnung mit unendlicher Impulsantwort ausgewählt werden; und

eine zweite Berechnungseinheit (44), die konfiguriert ist, um die Übergangstemperatur des HF-Leistungs-MOSFET durch Eingeben einer tatsächlichen Eingabe in das Modell für die Übergangstemperaturkompensation zu berechnen.

10. Gerät nach Anspruch 9, wobei die erste Berechnungseinheit (42) Folgendes umfasst:

eine dritte Berechnungseinheit (421), die konfiguriert ist, um eine Transferfunktion im Frequenzbereich des Modells für die transiente thermische Impedanz zu berechnen;

eine Umwandlungseinheit (422), die konfiguriert ist, um die Transferfunktion im Frequenzbereich des Modells für die transiente thermische Impedanz unter Verwendung von bilinearer Transformation in die Transferfunktion im Zeitbereich des Modells für die transiente thermische Impedanz umzuwandeln.

11. Gerät nach Anspruch 9, wobei die vorzuziehende Abtastfrequenz zum Erstellen des Modells für die Übergangstemperaturkompensation als 10 kHz ausgewählt wird.

12. Gerät nach Anspruch 9, wobei der vorzuziehende Typ von Filterstruktur zweiter Ordnung mit unendlicher Impulsantwort zum Erstellen des Modells für die Übergangstemperaturkompensation als Direkte-Form-II-Filterstruktur mit unendlicher Impulsantwort ausgewählt wird.

13. Gerät nach Anspruch 9, wobei die zweite Berechnungseinheit (44) konfiguriert ist, um die Übergangstemperatur des HF-Leistungs-MOSFET durch Software-Simulation zu berechnen.

14. Gerät nach Anspruch 9, wobei die zweite Berechnungseinheit (44) konfiguriert ist, um die Übergangstemperatur des HF-Leistungs-MOSFET durch FPGA zu berechnen.

15. Magnetresonanzbildgebungs (MRI)-System umfassend einen MRI-Verstärker, wobei das MRI-System ferner das Gerät nach einem der Ansprüche 8 bis 14 zur Berechnung der Übergangstemperatur von mindestens einem in dem MRI-Verstärker verwendeten HF-Leistungs-MOSFET umfasst.

**Revendications**

1. Procédé de calcul de la température de jonction d'un transistor MOSFET de puissance RF, comprenant les étapes consistant à :

   établir (S1) un modèle d'impédance thermique transitoire du transistor MOSFET de puissance RF dans le domaine analogique ;
   calculer (S2) une fonction de transfert dans le domaine temporel du modèle d'impédance thermique transitoire en utilisant une transformation bilinéaire ;
   sélectionner une fréquence d'échantillonnage préférable et un type préférable de structure de filtre IIR du $2^e$ ordre pour établir (S3) un modèle de compensation de température de jonction dans le domaine numérique sur la base de la fonction de transfert dans le domaine temporel du modèle d'impédance thermique transitoire ; et
   calculer (S4) la température de jonction du transistor MOSFET de puissance RF en saisissant une entrée réelle dans le modèle de compensation de température de jonction.

2. Procédé selon la revendication 1, dans lequel l'étape de calcul (S2) d'une fonction de transfert dans le domaine temporel du modèle d'impédance thermique transitoire comprend les étapes consistant à :

   calculer (S21) une fonction de transfert dans le domaine de fréquence du modèle d'impédance thermique transitoire ;
   convertir (S22) la fonction de transfert dans le domaine de fréquence du modèle d'impédance thermique transitoire en fonction de transfert dans le domaine temporel du modèle d'impédance thermique transitoire en utilisant une transformation bilinéaire.

3. Procédé selon la revendication 1, dans lequel l'étape de sélection d'une fréquence d'échantillonnage préférable comprend les étapes consistant à :

   établir une pluralité de modèles de compensation de température de jonction avec une pluralité de fréquences d'échantillonnage ;
   calculer une pluralité de températures de jonction en utilisant la pluralité de modèles de compensation de température de jonction stabilisée ; et
   sélectionner la fréquence d'échantillonnage qui entraîne la différence minimale entre une valeur de température théorique prédéterminée et les températures de jonction calculées comme fréquence d'échantillonnage préférable.

4. Procédé selon la revendication 1, dans lequel l'étape de sélection d'un type préférable de structure de filtre IIR du $2^e$ ordre comprend les étapes consistant à :

   établir une pluralité de modèles de compensation de température de jonction avec une pluralité de types de la structure de filtre IIR du $2^e$ ordre ;
   calculer une pluralité de températures de jonction en utilisant la pluralité de modèles de compensation de température de jonction stabilisés ; et
   sélectionner le type de la structure de filtre IIR du $2^e$ ordre qui entraîne la différence minimale entre la valeur de température théorique prédéterminée et les températures de jonction calculées comme type préférable de structure de filtre IIR du $2^e$ ordre.

5. Procédé selon la revendication 1, dans lequel la fréquence d'échantillonnage préférable est choisie à un niveau de 10 kHz.

6. Procédé selon la revendication 1, dans lequel le type de structure de filtre IIR du $2^e$ ordre est choisi sous la forme d'une structure de filtre IIR de forme directe II.

7. Procédé selon la revendication 1, dans lequel l'étape de calcul (S4) de la température de jonction du transistor MOSFET de puissance RF est mise en oeuvre par simulation de logiciel.

8. Procédé selon la revendication 1, dans lequel l'étape de calcul (S4) de la température de jonction du transistor MOSFET de puissance RF est mise en oeuvre par FPGA.

9. Appareil de calcul de la température de jonction d'un transistor MOSFET de puissance RF, comprenant :

une première unité d'établissement (41) configurée pour établir un modèle d'impédance thermique transitoire du transistor MOSFET de puissance RF dans le domaine analogique ;
une première unité de calcul (42) configurée pour calculer une fonction de transfert dans le domaine temporel du modèle d'impédance thermique transitoire en utilisant une transformation bilinéaire ;
une deuxième unité d'établissement (43) configurée pour établir un modèle de compensation de température de jonction dans le domaine numérique sur la base de la fonction de transfert dans le domaine temporel du modèle d'impédance thermique transitoire en sélectionnant une fréquence d'échantillonnage préférable et un type préférable de structure de filtre IIR du 2e ordre ;
une deuxième unité de calcul (44) configurée pour calculer la température de jonction du transistor MOSFET de puissance RF en saisissant une entrée réelle dans le modèle de compensation de température de jonction.

10. Appareil selon la revendication 9, dans lequel la première unité de calcul (42) comprend :

une troisième unité de calcul (421) configurée pour calculer une fonction de transfert dans le domaine de fréquence du modèle d'impédance thermique transitoire ;
une unité de conversion (422) configurée pour convertir la fonction de transfert dans le domaine de fréquence du modèle d'impédance thermique transitoire en fonction de transfert dans le domaine temporel du modèle d'impédance thermique transitoire en utilisant une transformation bilinéaire.

11. Appareil selon la revendication 9, dans lequel la fréquence d'échantillonnage préférable pour établir le modèle de compensation de température de jonction est choisie comme étant de 10 kHz.

12. Appareil selon la revendication 9, dans lequel le type préférable de structure de filtre IIR du 2e ordre pour établir le modèle de compensation de température de fonction est choisi sous la forme d'une structure de filtre IIR de forme directe II.

13. Appareil selon la revendication 9, dans lequel la deuxième unité de calcul (44) est configurée pour calculer la température de jonction du transistor MOSFET de puissance RF par simulation de logiciel.

14. Appareil selon la revendication 9, dans lequel la deuxième unité de calcul (44) est configurée pour calculer la température de jonction du transistor MOSFET de puissance RF par FPGA.

15. Système d'imagerie à résonance magnétique (MRI) comprenant un amplificateur MRI, dans lequel le système MRI comprend en outre l'appareil selon l'une quelconque des revendications 8 à 14 pour calculer la température de jonction d'au moins un transistor MOSFET de puissance RF utilisé dans l'amplificateur MRI.

Fig.1a

Fig.1b

2

```
┌─────────────────────┐
│         S1          │
└─────────────────────┘
           │
┌─────────────────────┐
│         S2          │
└─────────────────────┘
           │
┌─────────────────────┐
│         S3          │
└─────────────────────┘
           │
┌─────────────────────┐
│         S4          │
└─────────────────────┘
```

# Fig.2

S2

```
┌─────────────────────┐
│         S21         │
└─────────────────────┘
           │
┌─────────────────────┐
│         S22         │
└─────────────────────┘
```

# Fig.3

S3

S31

S32

# Fig.4

51

X(n)

$Z^{-1}$

$X_0$

$Z^{-1}$

$X_1$

$X_2$

53

Y(n)

$Z^{-1}$

$Z^{-1}$

$Y_1$

$Y_2$

52

# Fig.5

Fig.6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2012278029 A1

- US 2002118841 A1

### Non-patent literature cited in the description

- **YOUMIN YU et al.** *Compact thermal resistor-capacitor-network approach to predicting transient junction temperatures of a powe amplifier module,* July 2012

- **LEE J H et al.** *Large time-scale electro-thermal simulation for loss and thermal management of power MOSFET,* 15 June 2003